# EUROPÄISCHE PATENTSCHRIFT

(11) **EP 0 401 418 B1**
(45) Veröffentlichungstag und Bekanntmachung des Hinweises auf die Patenterteilung: **27.04.1994**
(21) Anmeldenummer: 89110472.1
(22) Anmeldetag: 09.06.1989
(51) Int. Cl.: H05K 9/00, H05K 7/14

(54) **Schirmeinrichtung für eine elektrische Baugruppe**
Shielding device for an electric module
Dispositif de blindage pour un équipement électrique

(43) Veröffentlichungstag der Anmeldung: 12.12.1990
(73) Patentinhaber: SIEMENS AKTIENGESELLSCHAFT, 80333 München (DE)
(72) Erfinder: Sedlmeier, Peter, Dipl.-Ing. (FH), D-8000 München 80 (DE); Busse, Ingeborg, D-8000 München 70 (DE); Mair, Eduard, D-8000 München 71 (DE)

(56) Entgegenhaltungen:
- DE-A- 3 604 860
- DE-U- 8 803 544
- FR-A- 2 571 922

## Beschreibung

Die Erfindung bezieht sich auf eine Schirmeinrichtung für eine in ein Baugruppenmagazin einschiebbare elektrische Baugruppe. Es ist bekannt (Siehe DE-U-8803 544.1), die Frontblenden der Baugruppe aus Metall herzustellen und daran gefiederte Kontaktbleche zu befestigen, die mit seitlichen Kontaktlappen versehen sind. Diese Kontaktlappen sind so ausgebildet, daß sie an der Frontblende der benachbarten Baugruppe anliegen. Die geerdeten Frontblenden ermöglichen zusammen mit den Kontaktblechen eine lückenlose elektrische Abschirmung der Baugruppen von der Frontseite her.

Moderne elektronische Schaltungen arbeiten mit sehr hohen Taktraten die eine Schirmung erfordern. Da die Frontblenden in der Reihe der Baugruppen elektrisch hintereinander geschaltet sind kommt es hier besonders auf einen geringen Kopplungswiderstand zwischen den Frontblenden an. Dieser Forderung steht entgegen, daß die Frontblenden und die Kontaktbleche aus unterschiedlichen Materialien bestehen, was zur elektrischen Korrosion führt und daß pro Frontblende zwei elektrische Übergänge vorhanden sind.

Der Erfindung liegt die Aufgabe zugrunde, den elektrischen Widerstand und den Fertigungsaufwand zu verringern.

Diese Aufgabe wird durch die Erfindung gemäß Anspruch 1 gelöst. Da nun das Schirmblech unmittelbar mit dem benachbarten Schirmblechen kontaktierbar ist, verringert sich die Anzahl der elektrischen Übergänge pro Frontblende. Es werden jeweils gleiche Materialien miteinander kontaktiert, was die Gefahr von elektrischer Korrosion verringert. Dadurch werden die Übergangswiderstände erheblich reduziert, so daß entstehende Störströme besser abfließen können.

Da das Schirmblech die gesamte Frontblende überdeckt, kann es mit Hilfe geeigneter Rastmittel in einfacher Weise an der Frontblende gehalten werden, so daß sich der Montageaufwand entsprechend verringert. Ein wesentlicher Vorteil besteht ferner darin, daß nun die Frontblende kostengünstig aus Kunststoff hergestellt werden kann, da sie nicht mehr für die Schirmung bzw. Kontaktierung benötigt wird.

Vorteilhafte Weiterbildungen der Erfindung sind in den Ansprüchen 2 bis 11 gekennzeichnet:
Durch die Weiterbildung nach Anspruch 2 ist es möglich, die nicht federnden Kontaktstellen in einer definierten Ebene anzuordnen, so daß sich gleichmäßige Kontaktbedingungen einstellen lassen.

Durch die Weiterbildung nach Anspruch 3 ergeben sich größere Variationsmöglichkeiten hinsichtlich der Ausgestaltung der Kontakte.

Durch die Weiterbildung nach Anspruch 4 können größere Abstandstoleranzen zwischen den Frontblenden ausgeglichen werden.

Die Weiterbildung nach Anspruch 5 ermöglicht eine enge Verzahnung der Kontaktlappen mit den nichtfedernden Kontaktstellen bei einer hohen Anzahl von Kontakten mit entsprechend großer Kontaktfläche.

Durch die Weiterbildung nach Anspruch 6 können an alle Frontblenden gleiche Schirmbleche in gleicher Orientierung angebracht werden.

Die Weiterbildung nach Anspruch 7 kann bei beiden Kontaktierungsarten angewendet werden. Bei der Kombination von federnden Kontaktlappen mit festliegender Gegenkontaktstelle sind die Kontaktlappen von Baugruppe zu Baugruppe jeweils um eine halbe Teilung versetzt. Dies läßt sich günstig dadurch erreichen, daß das Schirmblech an einem Ende einen Kontaktlappen und am anderen Ende eine festliegende Kontaktstelle aufweist und daß die Schirmbleche in wechselnder Orientierung an den Frontblenden befestigt werden. Wird jedoch ein Kontakt von Kontaktlappen zu Kontaktlappen gewünscht, so werden die Schirmbleche in gleicher Orientierung an den Frontblenden befestigt.

Die Weiterbildung nach Anspruch 8 nutzt die Federeigenschaften des Schirmblechs auch für die Befestigung an der Frontblende.

Die Weiterbildung nach Anspruch 9 ergibt eine große Anzahl von Haltelappen, so daß die beim Ziehen der Baugruppe auftretenden Kräfte sicher abgefangen werden.

Durch die Weiterbildung nach Anspruch 10 können die Haltelappen besonders vorteilhaft auch als Kontaktstellen genutzt werden.

Die Kontaktlappen nach Anspruch 11 lassen sich günstig biegen und ergeben gute Federeigenschaften.

Im folgenden wird die Erfindung anhand eines in der Zeichnung dargestellten Ausführungsbeispieles näher erläutert.
- Fig. 1: zeigt perspektivisch einen Teil zweier benachbarter Baugruppen mit Frontblenden und Schirmblechen,
- Fig. 2: zeigt eine Draufsicht auf die Teile nach Figur 1.

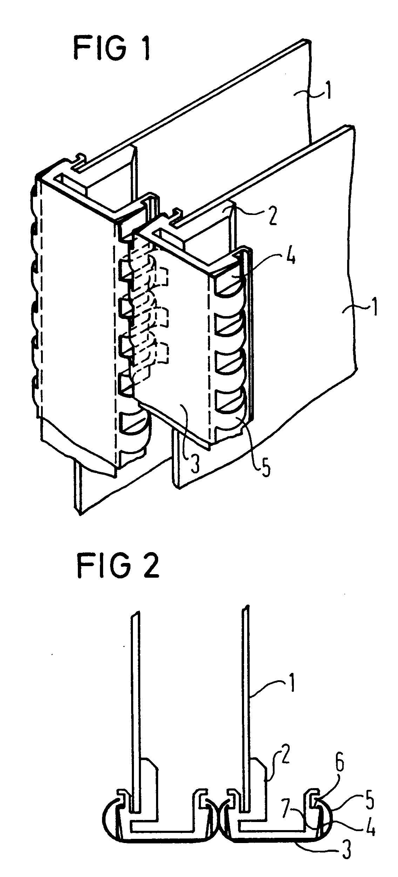

Nach den Figuren 1 und 2 sind zwei elektrischen Baugruppen in ein nicht dargestelltes Magazin eingeschoben. Die Baugruppen weisen Leiterplatten 1 auf, an die frontseitig aus Kunstoff bestehende Frontblenden 2 angesetzt sind. Auf die Frontblenden sind Schirmbleche 3 aufgeschnappt. Die im wesentlichen u-förmig gebogenen Schirmbleche 3 weisen an ihren Längsseiten in abwechselnder Reihenfolge Haltelappen 4 und Kontaktlappen 5 auf, die durch Scheren und unterschiedliches Abbiegen erzeugt sind. Dabei überragen die Kontaktlappen 5 die Haltelappen 4. Die Lappen sind zu beiden Längsseiten des Schirmblechs spiegelbildlich angeordnet.

Das Schirmblech 3 erstreckt sich über die gesamte Länge und Breite der Frontblende 4. Die Kontaktlappen 5 sind mit Kontaktlappen 5 der benachbarten Baugruppen kontaktiert. Dadurch wird die gesamt Frontseite des vollbestückten Magazins hochfrequenzdicht abgedeckt.

Die Haltelappen 4 sind senkrecht zur Frontseite der Baugruppen abgewinkelt. Das freie Ende der Haltelappen 4 ist zur Frontblende 2 hin abgeknickt und hintergreift diese an einer entsprechenden Rastschulter 6. Die Frontblende 2 ist mit seitlichen Auflaufschrägen 7 für die Haltelappen 4 versehen.

Die seitlichen Kontaktlappen 5 sind halbkreisförmig in sich zurückgebogen und überragen die Frontblenden 2 in Richtung der benachbarten Frontblenden soweit, daß sie sich federnd gegen die Kontaktlappen 5 der benachbarten Schirmbleche 3 drücken. Aufgrund der Vielzahl der Kontaktlappen 5 ist somit ein großflächiger Kontakt zwischen den Schirmblechen 3 gegeben.

## Patentansprüche

1. Schirmeinrichtung für eine in ein Baugruppenmagazin einschiebbare elektrische Baugruppe, bestehend aus einem an der Frontblende (2) der Baugruppe befestigbaren, streifenförmigen Kontaktblech, das sich in der Längsrichtung der Frontblende (2) erstreckt und zu benachbarten Frontblenden hin eine Vielzahl von federnden Kontaktlappen (5) aufweist, die mit den Schirmteilen der benachbarten Baugruppen kontaktierbar sind,
**dadurch gekennzeichnet,**
daß das als Schirmblech (3) ausgebildete Kontaktblech die gesamte Frontblende (2) überdeckt und mit beiden Schirmblechen (3) der benachbarten Baugruppen unmittelbar kontaktierbar ist.

2. Schirmeinrichtung nach Anspruch 1,
**dadurch gekennzeichnet,**
daß die gefiederten Kontaktlappen (5) entlang einer Längsseite des Schirmblechs (3) und die Gegenkontaktstellen nicht federnd ausgebildet sind.

3. Schirmeinrichtung nach Anspruch 1 oder 2,
**dadurch gekennzeichnet,**
daß die Kontaktlappen (5) auf beiden Längsseiten des Schirmblechs (3) ausgebildet sind.

4. Schirmeinrichtung nach Anspruch 3,
**dadurch gekennzeichnet,**
daß jeweils zwei Kontaktlappen (5) benachbarter Schirmbleche (3) miteinander kontaktierbar sind.

5. Schirmeinrichtung nach Anspruch 3,
**dadurch gekennzeichnet,**
daß auf jeder Längsseite des Schirmblechs (3) in wechselnder Reihenfolge die federnden Kontaktlappen (5) und nicht federnden Kontaktstellen angeordnet sind, daß jeweils ein Kontaktlappen (5) eines Schirmblechs auf eine nicht federnde Kontaktstelle des benachbarten Schirmblechs (3) trifft und daß die nicht federnden Abschnitte breiter sind als die federnden Kontaktlappen (5).

6. Schirmeinrichtung nach Anspruch 5,
**dadurch gekennzeichnet,**
daß bei einem Schirmblech (3) jeweils ein Kontaktlappen (5) einer nicht federnden Kontaktstelle gegenüber liegt.

7. Schirmeinrichtung nach Anspruch 5 oder 6,
**dadurch gekennzeichnet,**
daß die Kontaktlappen (5) zu beiden Seiten des Schirmblechs (3) spiegelbildlich angeordnet sind.

8. Schirmeinrichtung nach einem der vorhergehenden Ansprüche,
**dadurch gekennzeichnet,**
daß das Schirmblech (3) auf die Frontblende (2) mittels Haltelappen (4) aufschnappbar ist, deren federnde Enden die Frontblende (2) hintergreifen.

9. Schirmeinrichtung nach Anspruch 8,
**dadurch gekennzeichnet,**
daß die Haltelappen (4) in den Zwischenräumen zwischen den Kontaktlappen (5) angeordnet sind.

10. Schirmeinrichtung nach Anspruch 9,
**dadurch gekennzeichnet,**
daß die Haltelappen (4) als die nicht federnden Kontaktstellen dienen.

11. Schirmeinrichtung nach einem der vorhergehenden Ansprüche,
**dadurch gekennzeichnet,**
daß die Kontaktlappen (5) halbkreisähnlich in sich zurückgebogen sind.

## Claims

1. Screening apparatus for an electrical assembly which is insertable into an assembly magazine, comprising a strip shaped contact plate which is securable to the front cover (2) of the assembly and which extends in the longitudinal direction of the front cover (2) and exhibits, towards adjacent front covers, a plurality of resilient contact tabs (5), with which contact can be made by the screening parts of the adjacent assemblies, characterized in that the contact plate, which is designed as a screening plate (3), covers the entire front cover (2) and can make direct contact with both screening plates (3) of the adjacent assemblies.

2. Screening apparatus according to Claim 1, characterized in that the feathered contact tabs (5) are designed along a longitudinal side of the screening plate (3) and the mating contact points are designed in non-resilient fashion.

3. Screening apparatus according to Claim 1 or 2, characterized in that the contact tabs (5) are designed on both longitudinal sides of the screening plate (3).

4. Screening apparatus according to Claim 3, characterized in that in each instance two contact tabs (5) of adjacent screening plates (3) can make contact with one another.

5. Screening apparatus according to Claim 3, characterized in that the resilient contact tabs (5) and non-resilient contact points are disposed on each longitudinal side of the screening plate (3) in alternating sequence, in that in each instance one contact tab (5) of a screening plate meets a non-resilient contact point of the adjacent screening plate (3), and in that the non-resilient portions are broader than the resilient contact tabs (5).

6. Screening apparatus according to Claim 5, characterized in that in the case of a screening plate (3), in each instance one contact tab (5) is situated opposite a non-resilient contact point.

7. Screening apparatus according to Claim 5 or 6, characterized in that the contact tabs (5) are disposed in mirror image fashion on both sides of the screening plate (3).

8. Screening apparatus according to one of the preceding claims, characterized in that the screening plate (3) can be snapped onto the front cover (2) by means of retaining tabs (4), the resilient ends of which engage behind the front cover (2).

9. Screening apparatus according to Claim 8, characterized in that the retaining tabs (4) are disposed in the interstices between the contact tabs (5).

10. Screening apparatus according to Claim 9, characterized in that the retaining tabs (4) serve as the non-resilient contact points.

11. Screening apparatus according to one of the preceding claims, characterized in that the contact tabs (5) are bent back into themselves in a manner similar to a semicircle.

## Revendications

1. Dispositif de blindage pour un module électrique pouvant être inseré dans un magasin à modules, constitué d'une tôle de contact en forme de bande, qui peut être fixée à la plaque avant (2) du module, qui s'étend dans la direction longitudinale de la plaque avant (2) et qui a une multiplicité de languettes élastiques de contact (5), qui s'étendent en direction de plaques avant voisines et qui peuvent établir un contact avec les parties de blindage des modules voisins, caractérisé par le fait que la tôle de contact, réalisée sous la forme d'une tôle de blindage (3), recouvre l'ensemble de la plaque avant (2) et peut établir un contact direct avec les deux tôles de blindage (3) des modules voisins.

2. Dispositif de blindage suivant la revendication 1, caractérisé par le fait que les languettes ramifiées de contact (5) s'étendent le long d'un grand côté de la tôle de blindage (3) et les zones de contact antagonistes sont agencées de manière à ne pas être élastiques.

3. Dispositif de blindage suivant la revendication 1 ou 2, caractérisé par le fait que les languettes de blindage (5) sont disposées sur les deux grands côtés de la tôle de blindage (3).

4. Dispositif de blindage suivant la revendication 3, caractérisé par le fait qu'un contact réciproque peut être établi entre respectivement deux languettes de contact de tôles de blindage (3) voisines.

5. Dispositif de blindage suivant la revendication 3, caractérisé par le fait que les languettes élastiques de contact (5) et des zones de contact non élastiques sont disposées selon une séquence alternée sur chaque côté longitudinal de la tôle de blindage (3), que respectivement une languette de contact (5) d'une tôle de blindage touche une zone de contact non élastique de la tôle de blindage voisine (3) et que les sections non élastiques sont plus larges que les languettes élastiques de contact (5).

6. Dispositif de blindage suivant la revendication 5, caractérisé par le fait que dans une tôle de blindage (3), chaque languette de contact (5) est en vis-à-vis d'une zone de contact non élastique.

7. Dispositif de blindage suivant la revendication 5 ou 6, caractérisé par le fait que les languettes de contact (5) sont disposées symétriquement, comme en un miroir, des deux côtés de la tôle de blindage (3).

8. Dispositif de blindage suivant l'une des revendications précédentes, caractérisé par le fait que la tôle de blindage (3) peut être encliquetée sur le panneau avant (2) au moyen de languettes de retenue (4), dont les extrémités élastiques s'accrochent derrière la plaque avant (2).

9. Dispositif de blindage suivant la revendication 8, caractérisé par le fait que les languettes de retenue (4) sont disposées dans les intervalles présents entre les languettes de contact (5).

10. Dispositif de blindage suivant la revendication 9, caractérisé en ce que les languettes de retenue (4) sont utilisées en tant que zones de contact non élastiques.

11. Dispositif de blindage suivant l'une des revendications précédentes, caractérisé par le fait que les languettes de contact (5) sont repliées sur elles-mêmes en forme de demi-cercle.
